# EUROPEAN PATENT APPLICATION

(11) **EP 0 939 321 A1**
(43) Date of publication of application: **01.09.1999**
(21) Application number: 98115530.2
(22) Date of filing: 18.08.1998
(51) Int. Cl.: G01R 31/319

(54) **High speed serial test and measurement equipment interface and system using same**

(30) Priority: 28.02.1998 US 32691
(71) Applicant: Hewlett-Packard Company, Palo Alto, California 94304 (US)
(72) Inventor: Atchison, Lee, Fort Collins, CO 80525 (US); Hill, Gregory, Loveland, CO 80537 (US); Berg, Nathan, Fort Collins, CO 80526 (US)
(74) Representative: Schoppe, Fritz, Dipl.-Ing.

(57) **Abstract**

A VXI compliant interface module (108) which plugs into a VXI test equipment environment (VXI mainframe (106)) and provides a high speed serial link 104 to a general purpose computer (102) operating as a controller of the test equipment. In particular, the VXI interface module (108) of the present invention utilizes an IEEE 1394 high performance serial bus (104, 200) as the interface between the controller (102) and the VXI mainframe (106) and bus (110). A processor (214) on the VXI interface module (108) interprets and processes VXI standard commands sequences including message based command/status sequences and register based command/status sequences. Standard software modules (300..306) on the general purpose computer (controller) exchange such commands and status in accordance with the VXI standards. A simple driver module (306) performs the encoding and decoding of the commands and status into for the IEEE 1394 serial signal standards. As compared to presently known VXI interface solutions, the present invention is simpler while maintaining a high level of performance. Simplicity, hence lower cost, is achieved through enabling use of a standard general purpose computer (i.e., personal computer 102 or workstation) as a controller as compared to prior custom VXI "plug-in" controllers and through use of a narrow (e.g., one bit wide) serial connection bus (104) as compared to prior wide parallel bus cables and structures.

## Description

### Background of the Invention

### 1. Field Of the Invention

The present invention relates to controller/test equipment interconnection and in particular to a high performance serial interface for connecting a controller to a VXIbus test equipment mainframe.

### 2. Discussion of Related Art

It is widely known in the electronic testing and measurement arts to use computers (i.e., general-purpose personal computers and workstations) to control electronic test equipment. For example in a laboratory, or in a quality assurance test environment, a significant number of electronic test devices may be in use to evaluate characteristics, performance, quality, etc., of a product, compound, or process. The computer acts as a controller to manage configuration and operation of the various test and measurement devices in order to conduct the desired test sequence.

Historically, such test and measurement instruments have been connected to a computer controller via any of several standardized as well as proprietary bus interfaces. For example, IEEE 488 (also commonly referred to as HPIB and GPIB) has been widely used in the control and configuration of test and measurement equipment. More recently, a bus standard often referred to as VXIbus (or simply VXI) has become a popular solution for connection of computers to test and measurement equipment. The VXIbus standards are generally available from IEEE as specification IEEE 1155-1992. VXIbus standards provide a number of extensions to the widely used VMEbus specifically oriented toward connection and control of test and measurement equipment. As compared to IEEE 488, VXI provides substantially higher data throughput. The controller in a VXI environment communicates with the test and measurement instruments using any of two control/status standards, namely message based controls and register programming based controls.

The VXI standard defines high level command and status structures exchanged between the controller and the VXI test and measurement equipment. The high level command and status structures define higher level operations to be performed by an identified component in the test and measurement equipment. In the register based model of programming test equipment, the VXI standards allow for definition of an arbitrarily large set of registers for each component in the test and measurement equipment in the VXI environment (where "registers" are addressable locations for reading and writing of values). The controller reads and writes values from and to the registers of each of the components required to perform a desired step in the test and measurement sequence.

To communicate between the test and measurement instruments and the controller in a VXIbus environment, presently known techniques generally utilize one of two architectures to extend the VXIbus signals to the controller circuits and software. In one architecture, a general-purpose computer (controller) is embedded within the VXIbus environment along with the instruments and equipment to be controlled. In other words, the controller is simply another card which plugs into the VXIbus (backplane) of the VXI test environment along with the various test and measurement components. This solution is costly in that though the controller includes essentially all components of a general-purpose computer, it does so in an embedded, customized form factor. Standard, mass marketed, personal computers and workstations are simpler (due in large part to their mass production) and therefore less costly than such customized "plug-in" controllers.

A second general architecture utilized by presently known solutions provides for a customized parallel bus structure interconnecting a standard personal computer or workstation with the VXIbus test and measurement equipment. For example, a special purpose adapter within the general purpose computer may adapt signals on the bus of the computer (e.g., a PCI bus) to signals appropriate for exchange with the VXIbus. A wide parallel bus cable is typically utilized to connect the two bus structures, namely the PCI bus of the general-purpose computer and the VXIbus of the test and measurement equipment.

Both techniques essentially extend the signals on the VXIbus (backplane) to a controller which then applies signals directly to the VXIbus to control the test and measurement equipment. In the embedded "plug-in" approach, the VXIbus is simply integrated with the controller circuit design. In the cabled interconnect approach, a wide parallel bus cable is extended between the VXIbus and the controller's bus. Though such bus adaptation provides for very high throughput of data, such parallel bus structures are inherently expensive. In particular, the sheer number of parallel bus signals to be transmitted and received increases the cost and complexity by increasing the number of transceiver and buffering electronic circuits required to transmit and receive the adapted signals. Furthermore, to reduce potential interference by noise signals and parallel bus signal paths, a large number of grounding or shielding signal paths must accompany the parallel bus structure as transferred over the wide parallel cable. To further improve noise immunity, such parallel bus structures are often limited in their cable lengths both with respect to cabling intermediate each device and the total aggregate cabling length where multiple devices are chained to the bus structure.

Presently known solutions therefore increase cost and complexity for the benefit of improved data throughput performance.

In view of the above discussion, it is evident that a need exists for an interface connection between general-purpose computers acting as instrument controllers and the associated VXI compatible array of test and measurement equipment (one or more VXI mainframes). The need is for simpler, hence lower cost, high performance interconnection of the controller and the VXI compatible test and measurement equipment.

### Summary of the Invention

The present invention solves the above and other problems, thereby advancing the state of the useful arts, by providing for use of a high-speed serial bus to interconnect a general-purpose computer controller and the associated VXI compatible test and measurement equipment. More specifically, the present invention comprises a test and measurement system which includes a VXI compatible interface card which connects the external controller device (i.e., general-purpose personal computer or workstation) to the test and measurement equipment *i.e., VXI mainframes) via an industry standard high-speed serial bus architecture.

In the preferred embodiment, the VXI interface of the present invention receives and transmits information from and to the controlling computer utilizing an IEEE 1394 high-performance serial bus (also commonly referred to as a "Firewire"). The IEEE 1394 high-performance serial bus provides for a one bit serial interface connection with data speeds as high as 400 Mbps. The single bit serial interface permits enhanced noise immunity while maintaining simplicity of design as compared to wide parallel bus cabling architectures (thereby reducing costs). Control and data are exchanged between the VXI interface of the present invention and a standard, commercially available IEEE 1394 interface card resident in the general-purpose computer acting as a controller.

As noted above, the command/status structure between the controlling computer and the VXI interface, as defined by the VXI standards, permits use of a message based architecture as well as a register based architecture. The VXI interface of the present invention permits use of the same command/status structures. Software layers associated with the present invention transfer such commands and status information (i.e., messages and register values) via the IEEE 1394 serial bus. A high-speed FIFO with associated address and data state machine logic permits high-speed burst transfers of data between the VXIbus and the controller via the IEEE 1394 serial interface.

A next layer of communication protocol between the controlling computer and the VXI interface provide for reliable, packet/transaction oriented communications of such VXI command/status structures. The packet oriented protocol layers provide for reliable transfer of the command/status messages through transaction oriented acknowledgment of messages sent and received. Each command or status message includes in the transaction any associated data (i.e., command parameter data and status message data). Program instructions which implement the higher level protocol layers for such information exchange are maintained in coordinated versions by allowing the controlling computer to update the program instructions (software/firmware) within the VXI interface.

The VXIbus interface card of the present invention includes a processor for implementing the transaction oriented communication protocols and for interpreting and processing commands and data received from the general-purpose computer via the IEEE 1394 serial interface. In accordance with the VXI public standards, both message based command structures and register based structures are supported and processed by the processor. Standard test and measurement support software libraries and modules resident in the general-purpose computer (controller) may therefore be utilized essentially unchanged for generating VXI standard control and status sequences.

Use of an IEEE 1394 high-speed serial interface in accordance with the present invention provides a high-performance VXI compatible interface in a substantially simpler and hence less costly solution than is presently known. Simplicity and lower costs are achieved primarily through two aspects of the present invention. First, the VXI interface of the present invention may connect with any standard commercially available personal computer or workstation as a controller as compared with prior solutions which included a customized controller embedded within the VXIbus environment. Secondly, the high-speed single bit serial interface (IEEE 1394 serial interface) provides high-performance with a simpler, lower-cost, narrow bus interconnecting the controller and the VXI equipment as compared to prior techniques utilizing wide parallel buses. An additional benefit of the present invention is realized in the extended cable length and flexible topology options provided by the IEEE 1394 serial interface standards as compared to prior wide parallel bus techniques.

More generally, the present invention may be advantageously applied to any instrumentation control/communication link between a controlling device (e.g., a general purpose computer or workstation) and a test and measurement equipment environment. VXI applications are representative of one such test and measurement environment where the present invention may be advantageously applied. Other test and measurement environments wherein complex, costly, parallel bus structures and cables are utilized for communication between a controlling computer or device and the test and measurement equipment may similarly benefit from application of the present invention.

The above, and other features, aspects and advantages of the present invention will become apparent from the following descriptions and attached drawings.

### Brief Description of the Drawings

Figure 1 is a block diagram of a test and measurement system in which the VXI interface module of the present invention is advantageously applied.
Figure 2 is a block diagram depicting additional details of the VXI interface of the present invention as shown applied in Figure 1.
Figure 3 is a block diagram depicting an exemplary preferred structure for software operable in the system of Figure 1 utilizing the VXI interface module of the present invention.
Figure 4 is a block diagram providing additional details of the VXIbus interface portion of circuits in the VXI interface module of figure 1.

### Detailed Description of the Preferred Embodiments

While the invention is susceptible to various modifications and alternative forms, a specific embodiment thereof has been shown by way of example in the drawings and will herein be described in detail. It should be understood, however, that it is not intended to limit the invention to the particular form disclosed, but on the contrary, the invention is to cover all modifications, equivalents, and alternatives falling within the spirit and scope of the invention as defined by the appended claims.

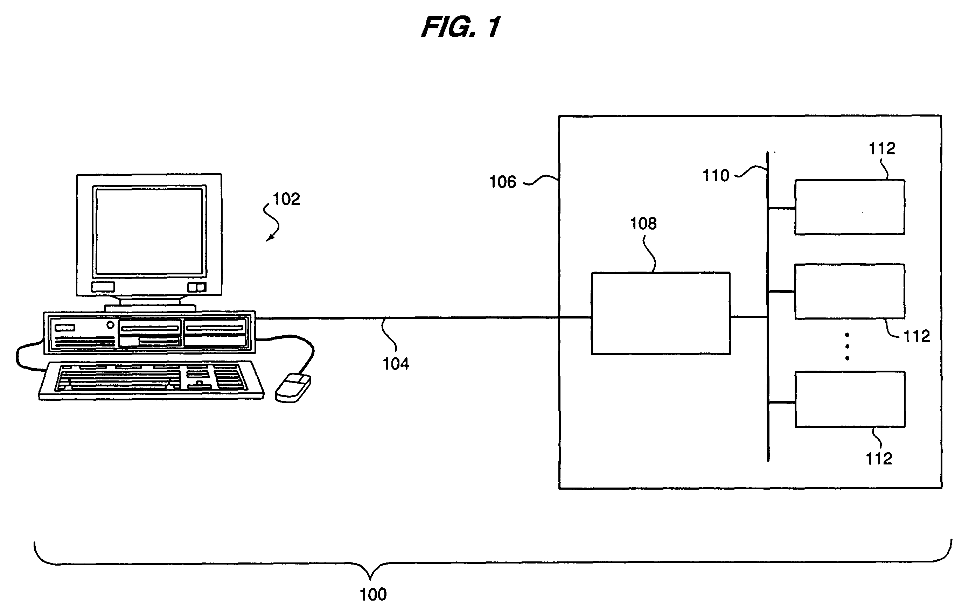

Figure 1 is a block diagram depicting a system utilizing the VXI interface module of the present invention in a test and measurement environment. System 100 includes general-purpose computer 102 operable as a controller to perform desired test and measurement sequences in accordance with test and measurement application software operable thereon. VXI mainframe 106 is representative of an exemplary test and measurement environment coupled to the controller (computer 102) to perform desired test and measurement sequences. As noted above, though presented herein as related to VXI test and measurement environments, the communication/control interface architectures of the present invention may be advantageously applied to a wide variety of test and measurement environments. Specifically, the high speed serial communication link between the controller (computer 102) and VXI mainframe 106 may be utilized in conjunction with a wide variety of test and measurement environments wherein complex, costly parallel bus structures have been commonly applied.

VXI mainframe 106 includes one or more VXI compliant test and measurement devices 112 commonly attached to VXIbus backplane 110. VXI interface module 108 of the present invention serves to adapt signals for exchange between general-purpose computer 102 and VXI mainframe 106. In particular, in accordance with the present invention, VXI interface module 108 is coupled to VXIbus backplane 110 in common with VXI compliant test and measurement devices 112. Further, in accordance with the present invention, VXI interface module 108 is coupled to general-purpose computer 102 via high-speed serial bus 104. In the preferred embodiment of the present invention, and as discussed above, high-speed serial bus 104 is preferably an IEEE 1394 compliant high-speed bit serial bus.

As noted above, the system as depicted in figure 1 provides high-speed communications between general-purpose computer 102 (performing as a controller) and VXI mainframe 106. However, system 100 of figure 1 provides this high performance level with notable simplification, and hence a lower-cost, as compared to presently known techniques. In particular, as noted above, high-speed serial bus 104 permits high-performance communication between computer 102 and VXI mainframe 106 while simplifying cabling requirements, enhancing noise immunity, and providing topology flexibility as compared to previously known techniques. More specifically, high-speed bit serial bus 104 utilizes a substantially simpler cabling configuration as compared to wide parallel bus structures and associated complex cabling structures as presently known in the art.

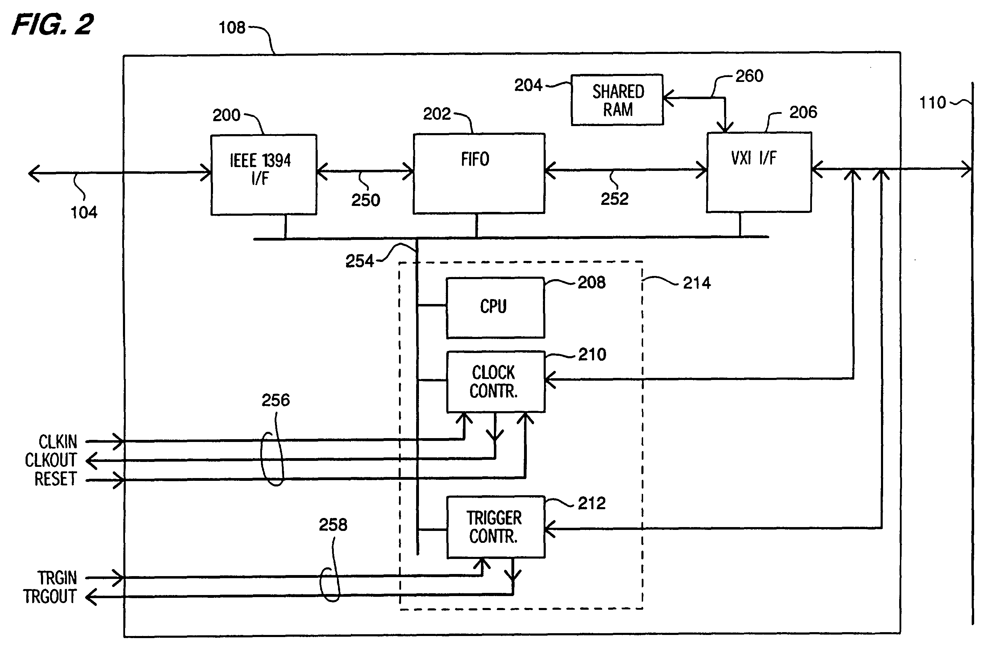

Figure 2 is a block diagram describing in additional detail the structure of VXI interface module 108. At the heart of VXI interface module 108 is controller 214 which manages overall operation of VXI interface module 108. In particular CPU 208 is a general-purpose processor programmed to control the exchange of information between high-speed serial bus 104 and VXIbus backplane 110. Control and status commands are exchanged in accordance with either message based standards or register based standards defined by the VXI standards. CPU 208 therefore interprets and translates such command and status requests and data as required to control test and measurement equipment within the VXI mainframe. In the best presently known mode of practicing the invention, CPU 208 is preferably a TMS320F206 digital signal processor (DSP) device produced by Texas Instruments. This particular chip, and digital signal processing devices in general, tend to include specialized instructions well-suited for high-speed data transfer applications. Those skilled in the art will readily recognize that any of several similar and equivalent custom circuits (e.g., ASIC devices), general-purpose processors, or digital signal processor devices may be utilized in place of CPU 208.

Preferably, CPU 208 includes embedded within it any requisite general-purpose timer circuits, program and data memory (e.g., RAM, ROM, and/or Flash memories to the extent that CPU 208 is a programmable device), and other related peripheral components.

Also included within controller 214 is clock control element 210 and trigger control element 212. Clock control element 210 performs clock and other management functions as defined by the VXI standards for any VXI module operable in a VXI mainframe. Specifically, in the preferred embodiment, clock control element 210 includes VXI standard clock generation (16 MHz and 10 MHz clock signals) as well as connectors for external clock management. In particular, external connectors for clock in (CLKIN) and clock out (CLKOUT) signals (external signal bus 256) are provided to permits receipt of externally generated clock signals and to permit application of internally generated clock signals to external devices. The VXI standards provide for a nominal 10 MHz clock being applied to the CLKIN signal path. A driver circuit in clock control element 210 selects either the internally generated 10 MHz clock signal or the externally applied clock signal on the CLKIN signal path to appropriate signals on the VXI backplane 110. The selected 10 MHz clock signal is also applied to the CLKOUT signal path. This permits use of a single (therefore synchronized) clock signal applied to all VXI modules within potentially multiple VXI mainframes.

Further, clock control element 210 includes other general management functions as defined by the VXI standards. For example, clock control element 210 may include module identification circuits (MODID driver/sensors) as provided in the VXI standards for uniquely identifying VXI modules, power and reset management monitoring functions, VXIbus arbitration circuits, and interrupt acknowledgment Daisy chain circuits. Those skilled in the art will readily recognize a variety of standard system and bus management functions defined by VXI standards and required for VXIbus backplane interfacing which may be incorporated in custom circuits within clock control element 210.

Trigger control element 212 within controller 214 provides trigger management and routing functions defined by VXI standards. In particular, trigger control element 212 processes routing of external trigger signals to or from the VXIbus backplane 110 as defined by VXI standards. More specifically, trigger control element 212 includes circuits and logic for receiving externally generated trigger signals (TRGIN) and circuits and logic for applying trigger signals generated within the VXI mainframe to external devices (TRGOUT) via external signal bus 258. Those skilled in the art will readily recognize a variety of standard trigger and bus management functions required for VXIbus backplane interfacing which may be incorporated in custom circuits within trigger control element 212.

VXI interface module 108 also includes any of several commercially available IEEE 1394 interface circuit 200. In the best presently known mode of practicing the invention, IEEE 1394 interface circuit 200 is preferably an IBM supplied chip set including a link layer chip (21S550) and a physical layer chip (21S850). Those skilled the art will recognize a variety of similar commercially available chips which may be applied in practice of the present invention for purposes of connecting VXI interface module 108 to IEEE 1394 high-speed serial bus 104 as well as other high-speed serial bus architectures. More generally, high-speed serial bus 104 and IEEE 1394 interface circuit 200 represents any devices and buses providing high-speed serial interfacing so as to realize the key benefit of the present invention, namely that of providing high-speed interface connections between a VXI mainframe and external controller device while simplifying, and hence reducing cost, as compared to presently known wide parallel bus structures. The preferred IEEE 1394 interface chipset provides for at least three Firewire connections. As is known in the art, three connections allows the Firewire connections to utilize a wide variety of topologies including daisy chains as well as more complex tree structures.

VXI interface module 108 further includes a high-speed FIFO 202 for enabling exchange of bursts of blocks of data at high speeds potentially beyond the capacity of CPU 208 alone. Details of an exemplary design of high-speed FIFO 202 are supplied in commonly assigned, co-pending patent application serial number **HPDN 10971962-1** entitled "**Three Port FIFO Data Buffer Having Multi-Level Caching.**" The three port FIFO preferably provides a three port buffer circuit that uses off the shelf static RAM and dedicated shallow, e.g., 16 word, FIFOs in a multi-level caching scheme. The FIFO results in multiple, reconfigurable, deep; (e.g., up to 32k word) FIFO buffers. The preferred embodiment of FIFO 210 provides a buffer that comprises a bank of 32k word RAM, six dual port 16-word FIFOs, and associated sequencing logic. The sequencing logic includes RAM address registers/counter associated with each of the six FIFOs, and manages the movement of data into and out of the RAM. Those skilled in the art will recognize a variety of equivalent design options for providing the function of high speed FIFO 202 in the context of the present invention.

VXI interface module 108 further includes shared RAM element 204. Those skilled in the art will recognize that shared RAM element 204, associated with VXI interface 206 supplies optional shared access memory for VXI module interfacing. Standard VXI protocols and register values define the location of the shared RAM

VXI interface module 108 also includes VXIbus interface element 206 for connecting VXI interface module 108 to VXIbus backplane 110. Shared RAM element 204 is associated with VXIbus interface element 210 via bus 260 as provided in the VXIbus standards. Shared RAM element 204 may be used by test and measurement applications for communication among the various VXI modules as provided for in the VXI standards.

In general, circuits within VXIbus interface element 206 provide adaptation and control of signals on VXIbus backplane 110 relating to control, data, address, and interrupt signaling. In addition, logic and circuits within VXIbus interface element 206 manipulate required VXIbus backplane 110 signals to manage registers within VXI interface model 108. VXI registers as defined by the VXI standards are provided by circuits within VXIbus interface element 206.

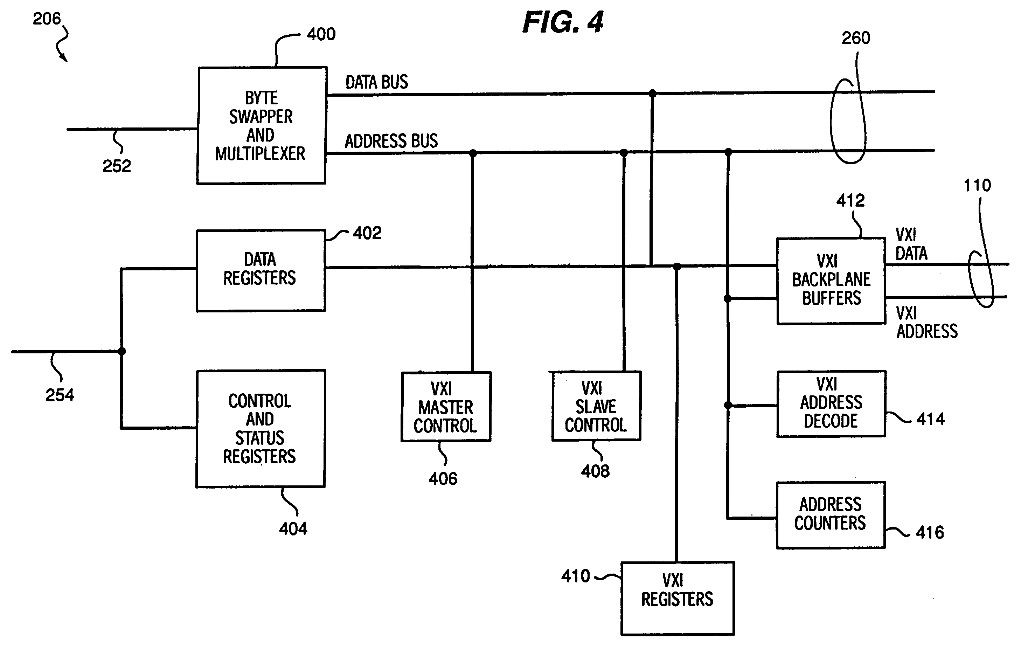

Figure 4 is a block diagram providing additional detail of the structure of VXIbus interface element 206. VXI backplane buffers 412 provide electronic buffering of data and address signals received from and applied to VXIbus backplane 110 in accordance with VXI standards. Byte swapper and multiplexor 400 routes data bytes from or to the VXIbus backplane 110 in the proper byte positions as required for interfacing to FIFO 202 of figure 2. Multiplexor 400 also multiplexes data and address signals for 64-bit transfer cycles. VXI master control 406 provides control of VME/VXIbus transactions on VXIbus backplane 110 in the role of a bus master. Likewise, VXI slave control manages VME/VXIbus transactions in the role of a bus slave. VXI registers 410 provide the message based device register set as described in the VXIbus standards. Data registers 402 provide registers for exchange of single word transactions between the controller 214 of figure 2 and the VXIbus backplane 110. Control and status registers 404 provide for configuring data transfers in the bus master role. VXI address decode 414 monitors the address bus signals on the VXIbus backplane 110 to identify transaction addressed to this VXI module. VXI address counters 416 generate address values for single word and multi-word exchanges in bus master transfers.

Bus 250 and 252 provide a path for high-speed direct exchanges of information between IEEE 1394 high speed serial bus 104 and VXIbus backplane 110 via IEEE 1394 interface circuit 200, and high-speed FIFO 202, and VXIbus interface element 206. Internal bus 254 provides interconnection of the various elements within VXI interface module 108. For example, CPU 208 controls operation of the various other elements via control and data signals exchanged over internal bus 254. Those skilled in the art will readily recognize a wide variety of design choices available for implementing internal buses 250, 252, and 254. Such design choices are well-known to those skilled the art and are largely dictated by the specific choice of components used for CPU 208 and other elements within VXI interface module 108.

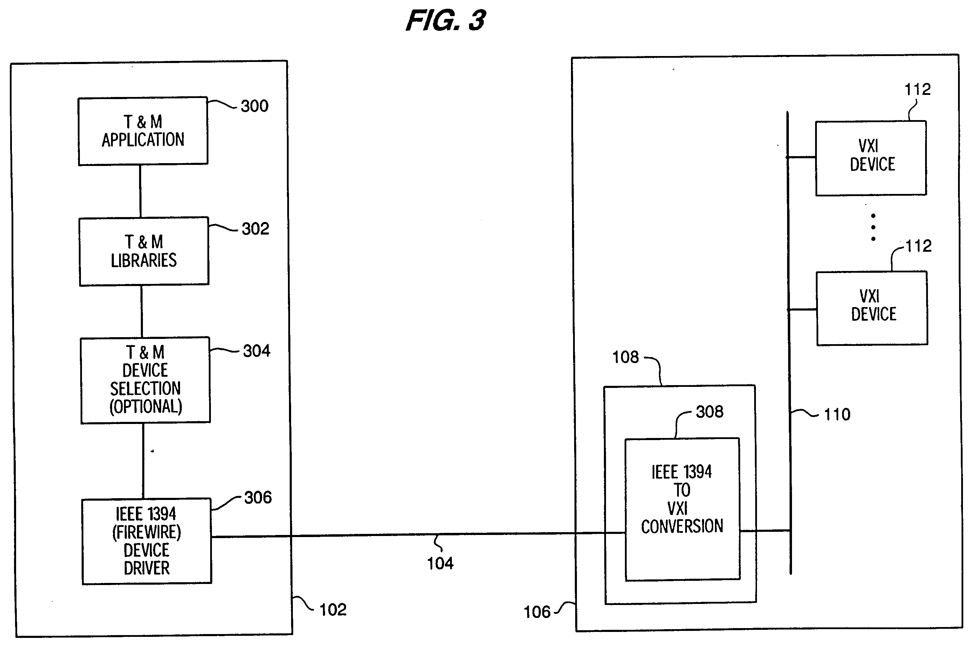

Figure 3 is a block diagram depicting layers of software operable within the system of figure 1 in accordance with the present invention. A test and measurement application program 300 operable within general-purpose computer 102 typically invokes standard test and measurement library functions 302 co-operable within general-purpose computer 102. Test and measurement library functions 302 may be any of several commercially available instrumentation library products including, for example, VISA (Virtual Instrument System Architecture as defined by VXI Plug and Play Systems Alliance at 6504 Bridge Point Parkway, Austin Texas, 78730) or SICL (Standard Instrument Control Library for C Programming as defined by Hewlett-Packard Company as published in United States Patent Number 5,361,336 entitled Method for Controlling an Instrument Through a Common Instrument Programming Interface). An optional test and measurement device selection module 304 is operable to select a particular device specific driver module appropriate to the particular link protocols and physical interface utilized between general-purpose computer 102 and VXI mainframe 106. In accordance with the present invention, an IEEE 1394 device driver module 306 is used within general-purpose computer 102 to adapt commands and data to be exchanged with VXI mainframe 106 to signals appropriate for application to, and reception from, IEEE 1394 high-speed serial bus 104. An IEEE 1394 to VXI conversion module 308 is operable within VXI interface module 108 in VXI mainframe 106. Conversion module 308 (firmware operable within CPU 208 of figure 2) converts signals to be applied to, or received from, IEEE 1394 high-speed serial bus 104 as required for exchange with VXIbus backplane 110.

Those skilled in the art will readily recognize that the particular distribution of software functions depicted in figure 3 is intended merely as exemplary of one preferred embodiment of the present invention. Numerous equivalent software and firmware modules may be provided in accordance with the design choices well-known to those skilled in the art to perform the functions described herein above.

### INTERFACE/COMPUTER PROTOCOLS

The VXI interface and system of the present invention utilizes a transaction oriented (packetized) protocol to assure reliable communication between the interface and the controlling computer. In general, each packet is transmitted by a transmitting device and acknowledged by the receiving device to assure proper transmission. Erroneously received packets are retransmitted as required to assure reception at the destination device.

All packets sent and received have the >Standard Packet= included at the beginning of the >data area= of the packet. Multiple packets may be linked to form a larger logical packet. Each such packet in a multi-packet read or write includes this Standard Packet header portion. Many commands also append command specific data to the end of the standard packet.

A state machine model serves to control the processing of various types of packets and the replies (if any) expected in response to transmission of the packets.

Each IEEE 1394 physical layer packet has a 64-bit address, 16 bits of which uniquely define a node on the bus. The higher level communication layers operating above the IEEE 1394 physical layer define and manage device addressing for devices in the test and measurement environment. Packets sent to one VXI device must be acknowledged as required before other packets will be sent to the same VXI device. This layer therefore allows for multiple logical connections between the controlling computer and the test and measurement environment over a single IEEE 1394 connection. Specifically, the protocol of the present invention allows for simultaneous connections including one IEEE 1394 physical interface transaction along with up to 255 logical device transactions. On each command, identification information specifies whether the command is to be directed over the single physical connection or to a specific device in the VXI mainframe.

Each packet sent to the VXI interface of the present invention has a corresponding acknowledge packet. The acknowledge packet indicates whether the transmitted packet was received, whether to try again later, or whether processing is pending.

While the invention has been illustrated and described in detail in the drawings and foregoing description, such illustration and description is to be considered as exemplary and not restrictive in character, it being understood that only the preferred embodiment and minor variants thereof have been shown and described and that all changes and modifications that come within the spirit of the invention are desired to be protected.

## Claims

1. A test and measurement equipment interface module (108) CHARACTERIZED IN THAT the module comprises:
a instrument bus interface element (206) for coupling said module to an instrument bus (110);
a high speed bit serial interface element (200); and
a processor (214) for coordinating exchange of command and status information between said instrument bus interface element (206) and said high speed bit serial interface element (200).

2. The interface module of claim 1 further comprising:
a FIFO (202) associated with said processor for buffering burst transfers of information between said instrument bus interface element (206) and said high speed bit serial interface element (200).

3. The interface module of claim 1 further comprising:
a clock control element (210) for managing clock signals associated with said instrument bus (110) wherein said clock control element includes:
a first connector (256 CLKIN) for accepting an externally generated clock signal; and
a second connector (256 CLKOUT) for applying internally generated clock signals to external devices.

4. The interface module of claim 1 further comprising:
a trigger control element (212) for managing trigger signals associated with said instrument bus (110) wherein said trigger control element includes:
a first connector (258 TRGIN) for accepting an externally generated trigger signal; and
a second connector (258 TRGOUT) for applying internally generated trigger signals to external devices.

5. The interface module of claim 1 wherein said high speed bit serial interface (200) is operable at speeds in excess of 200 Mbps.

6. The interface module of claim 1 wherein said high speed bit serial interface (200) is an IEEE 1394 compliant interface.

7. The interface module of claim 1 wherein said instrument bus (110) is a VXI compliant instrument bus and wherein said interface module (108) is a VXI compliant interface module.

8. A system (100) for control of test and measurement equipment CHARACTERIZED IN THAT the system comprises:
a controller (102) for operation of test and measurement sequences;
a VXI compliant mainframe (106) including at least one VXI compliant device (112);
a VXI compliant interface module (108) in said VXI mainframe (106);
a high speed bit serial bus (104) connecting said controller (102) to said VXI compliant mainframe (106) via said VXI compliant interface module (108).

9. The system of claim 8 wherein said high speed bit serial bus (104) is operable at speeds in excess of 200 Mbps.

10. The system of claim 8 wherein said high speed bit serial bus (104) is an IEEE 1394 compliant serial bus.

11. The system of claim 10 wherein said controller (102) is a general purpose computer.

12. The system of claim 8 wherein said VXI compliant interface module (108) includes:
a VXIbus interface element (206) connecting said module (108) to said VXI compliant mainframe (106);
a high speed bit serial interface element (200) connecting said module (108) to said high speed bit serial bus (104); and
a processor (214) for coordinating exchange of command and status information between said VXIbus interface element (206) and said high speed bit serial interface element (200).

13. The system of claim 12 wherein said VXI compatible module (108) further comprises:
a FIFO (202) associated with said processor (214) for buffering burst transfers of information between said VXIbus interface element (206) and said high speed bit serial interface element (200).

14. The system of claim 12 wherein said VXI compatible module (100) further comprises:
a clock control element (210) for managing VXI compliant clock signals wherein said clock control element (210) includes:
a first connector (256 CLKIN) for accepting an externally generated clock signal; and
a second connector (CLKOUT) for applying internally generated clock signals to external devices.

15. The system of claim 12 wherein said VXI compatible module (108) further comprises:
a trigger control element (212) for managing VXI compliant trigger signals wherein said trigger control element (212) includes:
a first connector (258 TRGIN) for accepting an externally generated trigger signal; and
a second connector (258 TRGOUT) for applying internally generated trigger signals to external devices.
